# EUROPEAN PATENT APPLICATION

(11) **EP 1 079 421 A1**
(43) Date of publication of application: **28.02.2001**
(21) Application number: 99115887.4
(22) Date of filing: 12.08.1999
(51) Int. Cl.: H01L 21/00

(54) **Overhead transport system for open cassette transport**

(71) Applicant: Semiconductor 300 GmbH & Co. KG, 01074 Dresden (DE)
(72) Inventor: Missale, Reiner, 93155 Hemau (DE)
(74) Representative: Epping, Wilhelm, Dr.-Ing.

(57) **Abstract**

The invention concerns an overhead transport system which is applicable for open cassette carriers. The invention comprises a hood (3) with an open bottom (5) connected to the transport vehicle (2) at a hanging manner so that the hood (3) is guided below the rail (1), an open wafer carrier (6) design for storing wafers (7) arranged within the liftable hood (3), and a minienvironment within the hood (3) to prevent the wafers (7) stored within the open wafer carrier (6) from particle contamination. The minienvironment is realized with an air stream from an air filter 9 at the top of the hood 3.

## Description

The present invention relates to an overhead transport system for open cassette transport with a rail mounted or secured at the top or at the ceiling of a room with transport vehicles guided by the rail and driven along the rail by a suitable drive system to transport wafers to several treatment tools.

Well known overhead transport systems are usable only for closed cassettes with the wafers stored at the clean inside. The reason therefore is that such transport systems provide only class 100 cleanliness or if class 1 or lower are not recommended to transport open cassettes because of contamination concerns. Therefore the known overhead transport systems work only for SMIF- (Standard Mechanical Interface) or FOUP (Front Opening Unified Pod)- containers. One example for a FOUP-transporting cassette is described within the DE 197 31 174 A1.

The transport of open cassettes without any box or container requires floorbased vehicles to ensure clean transport without contamination of the wafers stored within the cassette. Floorbased transport systems ensure that the source of particle contamination stays below the area where the cassette is located during the transport.

One of such a floorbased transport system is known from the DE 43 09 092 C2. This transport system according the described embodiement covers a chamber with the clean room class 1 or 0,1 with a rail within the chamber. The rail defines storing places for carrier with wafers stored within the carrier at a vertical alignment. The transport of the carrier is carried out by way of a lift mounted on a x-y-sledge.

Such a transport system is very expensive in manufacturing and can produce a particle contamination within the chamber. Therefore the chamber is connected to an exhaust system for maintaining the cleen room conditions.

Another new transport system uses the room over the ceiling of the clean room i.e. the mezzanine. At this embodiment the whole carrier storage and transport system is placed in this room. A robot arm transports the selected carrier (FOUP-Carrier) from the storage position to a lift device to transport the carrier down through a floodgate to a loadport of a treatment tool. The used carrier must be at a closed type.

This described transport system is effective but the installation is very expensive in cost and manufacturing.

### SUMMARY OF THE INVENTION

It is an object of the present invention to provide an overhead transport system which is applicable for open cassette carriers without need of any additional box or casing to improve the handling of the wafers stored on the cassette carrier.

Another object of the present invention is to provide an overhead transport system especially applicable for 300 mm wafers and what is easy to handle.

A further object of the present invention is to reduce the costs for the transport system and to improve the security for the serving personal.

In accordance with one object of the invention there is provided an overhead transport system with rails mounted at the top or at a ceiling of a room with transport vehicles guided by the rail and driven by a suitable drive system to transport wafers which comprises an automatic guided vehicle guided by the rail, a hood connected to the vehicle via connecting elements at a hanging manner so that the hood is guided below the rail, an open wafer carrier design for storing the wafers arranged within the hood and a minienvironment is realized within the hood to prevent the wafers stored on the open wafer carrier from particle contamination.

This solution ensures that particles produced by the overhead transport systen or other moved systems, even if class 1 or less is to maintain, are separated from the transport load i.e. the open wafer carrier with the wafers stored on board.

Therefore a slight air stream is to realize from the top to the bottom of the interieur of the hood.

Furthermore the hood contains an electrostatic air filter at the top, which enables proper maintenance to ensure always clean hood conditions.

As an alternative the hood contains a mechanical air filter at the top, which enables also a proper maintenance to ensure always clean hood conditions.

A further aspect of the invention is that the hood always stays with the vehicle and that the connecting elements are provided with a lifting device suitable to lift the hood down to a loadport of a treatment tool to unload/load wafers or to lift the hood after load/unload the wafers.

As an alternative the hood is provided with a lifting device to lift the open wafer carrier dowm to a loadport of a treatment tool or up whereby the hood stays at the transport vehicle.

Preferably the hood has an angle adjustment capability to ensure that the open wafer carrier is handled during transport at a given angle from the horizontal. This angle should be between 5 - 10E. This embodiement ensures the wafers from falling out of the open wafer carrier during transport or by shocks.

Within another aspect of the invention the hood contains at the open bottom of it a light reflector element which corresponds with a light source at the top side of a loadport and the loadport contains a light source to correspond with the light reflector element at the open bottom of the hood. This aspect of the invention ensures a proper positioning of the hood in relation to the loadport and the security for the serving personal is improved since the lift can be stopped if the light reflector does not receive the light from the light source. This case can happen if for instance the serve personal has a hand or another part of the body between the hood and the loadport.

To prevent the loadport and the hood with the open wafer carrier from any contamination it is prefered that a downward directed air stream is realized at the front of the treatment tool enclosing the loadport. This air stream should be a laminar air stream.

### BRIEF DESCRIPTION OF THEDRAWINGS

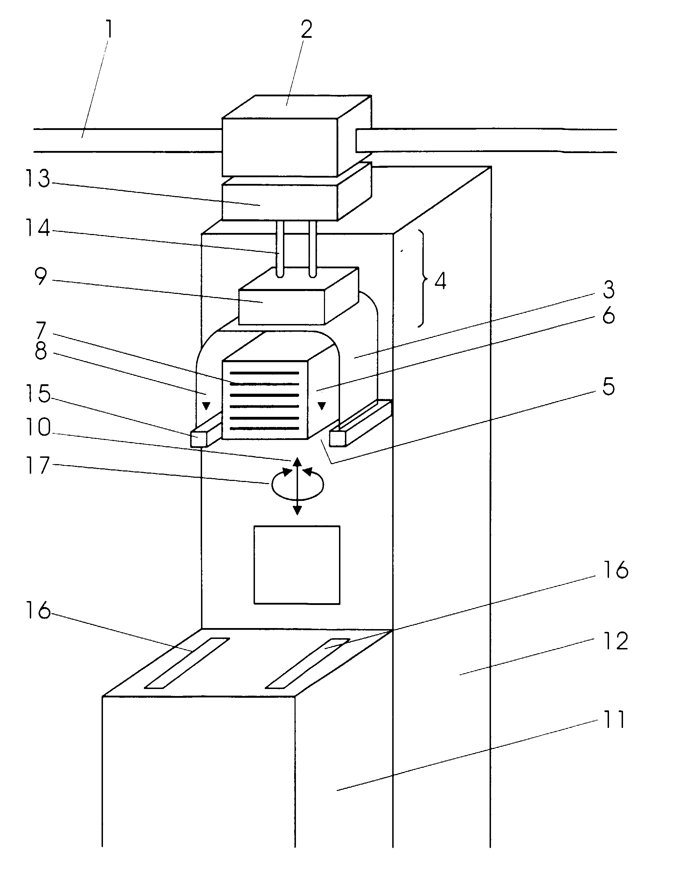

The enclosed drawing shows schematical an embodiement of the invention with an overhead transport system for open wafer carrier.

### DETAILED DESCRIPTION OF THE INVENTION

The overhead transport system according the invention consists of a rail 1 mounted at the top or at the ceiling of a room. On this rail 1 a transport vehicle 2 is guided and driven by a not shown drive system. Such a drive system can realized with an active system with well known driven ball bearings, with a linear step motor drive or with another electric motor drive.

With this transport vehicle 2 is connected a hood 3 at such a manner that the hood 3 is hanging below the rail 1 and the transport vehicle 2. The hood 3 follows the movement of the transport vehicle 2 which is secured and guided on the rail 1.

As seen from the drawing the hood 3 is connected to the transport vehicle 2 via connecting elements 4 and is provided with an interior with an open bottom 5. Within the interior an open wafer carrier 6 is secured to store and transport wafers 7. The open wafer carrier 6 has a "mushroom" interface to be handled as a 300 mm FOUP.

The hood 3 has an angle adjustment capability to ensure that the open wafer carrier 6 is handled during transport at a angle between 5 - 10E. This embodiement ensures the wafers 7 from falling out from the wafer carrier 6 during transport or by shocks.

Within the hood 3 is realized a minienvironment to prevent the wafers 7 from particle contamination. At this reason within the hood 3 is realized an slight air stream 8 from the top to the open bottom 5 of the hood 3. To clean the air to the necessary clean room class contains the hood 3 an electrostatic or mechanical air filter 9.

The hood 3 and the open wafer carrier 6 are vertical liftable at a up/down direction (indicated with arrow 10) from the transport vehicle 2 to a loadport 11 of a treatment tool 12 and return. Therefore the connecting element 4 is provided with a lifting device 13. This lifting device 13 has a not shown drive motor and cables 14 on which the hood 3 is secured. The lifting device 13 also can be provided with a turning element which can turn the hood 3 around a vertical axis (indicated with arrow 17) so that it is possible to move the hood 3 at such a position that the wafers 7 can be transfered into the treatment tool 12. This is helpful if several treatment tools 12 are arranged at an angle of 90E to each other.

Furthermore the hood 3 contains at the open bottom 5 of it a light reflector element 15 which corresponds with a light source 16 on the loadport 11. At this way a proper positioning of the hood 3 in relation to the loadport 11 is ensured and the security for the serving personal is improved since the lifting device can stop if the light reflector element 15 does not receive the light from the light source 16. This case can happen if for instance the serve personal has a hand or another part of the body between the hood 3 and the loadport 11.

To ensure that not any contamination could happen at the area of the loadport a downward directed air stream is realized at the front of the treatment tool 12 enclosing the loadport 11. This air stream should be a laminar air stream.

### LIST OF REFERENCE NUMERALS

- 1: rail
- 2: transport vehicle
- 3: hood
- 4: connecting element
- 5: open bottom
- 6: open wafer carrier
- 7: wafer
- 8: air stream
- 9: air filter
- 10: arrow (up/down direction)
- 11: loadport
- 12: treatment tool
- 13: lifting device
- 14: cable
- 15: light reflector element
- 16: light source
- 17: arrow

## Claims

1. An overhead transport system for open cassette transport with rails mounted at the top or at the ceiling of a room with transport vehicles guided by the rail and driven by a suitable drive system to transport wafers, comprising
a) a hood (3) with an open bottom (5) connected to the transport vehicle (2) at a hanging manner so that the hood (3) is guided below the rail (1),
b) an open wafer carrier (6) design for storing wafers (7) arranged within the hood (3), and
c) a minienvironment within the hood (3) to prevent the wafers (7) stored within the open wafer carrier (6) from particle contamination.

2. An overhead transport system according claim 1, wherein a slight air stream (8) is realized from the top to the open bottom (5) within the interieur of the hood (3).

3. An overhead transport system according claim 1 and 2, wherein the hood (3) contains an air filter (9) on the top, which enables proper maintenance of the minienvironment within the hood (3) to ensure always clean hood conditions.

4. An overhead transport system according claim 3, wherein the air filter (9) is of an electrostatic type.

5. An overhead transport system according claim 3, wherein the air filter (9) is of a mechanical type.

6. An overhead transport system according claims 1 to 5, wherein the hood (3) always stays with the transport vehicle (2).

7. An overhead transport system according one of the claims 1 to 6, wherein the connecting elements (4) are provided with a lifting device (13) so that the connecting elements (4) are suitable to lift the hood (3) down to a loadport (11) of a treatment tool (12) to unload/load the wafers (7) or to lift back the hood (3) to the transport vehicle (2) after unload/load the wafers (7).

8. An overhead transport system according one of the claims 1 to 6, wherein within the hood (3) is installed a lifting device to lift the open wafer carrier (6) down to a loadport (11) of a treatment tool (12) or up into the hood (3) whereby the hood (3) stays at the transport vehicle (2).

9. An overhead transport system according one of the claims 1 to 8, wherein the hood (3) has an angle adjustment capability to ensure that the open wafer carrier (6) is handled during transport at a given angle position from the horizontal.

10. An overhead transport system according claim 8, wherein the given angle is between 5 - 10E.

11. An overhead transport system according one of the claims 1 to 9, wherein the hood (3) contains at its open bottom (5) a light reflector element (15) which corresponds with a light source (16) at the loadport (11).

12. An overhead transport system according one of the claims 1 to 11, wherein the loadport (11) contains a light source (16) to correspond with the light reflector element (15) at the open bottom (5) of the hood (3).

13. An overhead transport system according one of the claims 1 to 12, whereby a downward directed air stream is realized at the front of the treatment tool (12) enclosing the loadport (11).

14. An overhead transport system according claim 13, wherein the air stream is a laminar air stream.
